# EUROPEAN PATENT APPLICATION

(11) **EP 2 410 825 A1**
(43) Date of publication of application: **25.01.2012**
(21) Application number: 10007538.1
(22) Date of filing: 21.07.2010
(51) Int. Cl.: H05K 1/11

(54) **Printed circuit board for telecommunication modules**

(71) Applicant: 3M Innovative Properties Company, Saint Paul, MN 55133-3427 (US)
(72) Inventor: Szymanki, Guenter, 44279 Wuppertal (DE); Edelmann, Wolfgang, 42111 Wuppertal (DE); Hajok, Johann, 44795 Bochum (DE); Bund, Christine, 42111 Wuppertal (DE)
(74) Representative: Bergen, Katja

(57) **Abstract**

A board, for example a printed circuit board 10 for insertion into a telecommunication module in an insertion direction 100, the printed circuit board 10 comprising a substrate 20, having two major surfaces 92, 94, first and second conductive paths 30, arranged on a major surface of the substrate 20, for electrically contacting first and second resilient contact elements of a linearly-arranged row of resilient contact elements of the telecommunication module, wherein the first and second conductive paths 30 are arranged such that a contacting end 35 of each of the conductive paths 30 is located on a straight reference line 110 which is substantially perpendicular to the insertion direction 100, so that electrical connections between respective resilient contact elements and the respective conductive paths 30 are established at one single insertion depth. The substrate 20 is shaped such that mechanical engagement between parts 25 of the substrate 20 which are to engage mechanically with the first and second resilient contact elements, respectively, and respective resilient contact elements is completed at different insertion depths of the board into the telecommunication module.

## Description

This invention relates to a board for insertion into a telecommunication module. It also relates to a combination of such a board with a telecommunication module.

Boards, such as for example printed circuit boards or "PCBs" are widely used in telecommunication applications. Such PCBs generally comprise an electrically non-conductive substrate and at least one conductive layer which forms conductive paths on the substrate. Mostly, these paths electrically connect electrical elements on the PCB with each other. Some PCBs have paths that form contact areas on the PCB, by which the PCB can be electrically connected to a device or to other PCBs. A particular type of PCB is the type that has such contact areas close to an edge of the PCB. A PCB having such "edge contacts" can be inserted with that edge into a telecommunication module, which normally has spring contacts for making electrical contact with the edge contacts of the PCB. One edge contact close to the edge of the PCB mostly corresponds to one spring contact of the telecommunication module. When the PCB is inserted into a telecommunication module, a straight edge of the PCB is often mechanically engaged with resilient contact elements of several spring contacts, such that each spring contact electrically connects to an edge contact of the PCB, when the PCB is fully inserted into the telecommunication module.

In order for the electrical contact between an edge contact and a spring contact to be reliable, the spring contact needs to be pressed against the edge contact with an appropriate mechanical force. For that purpose, the spring constant of a spring contact in a telecommunication module is often quite high, i.e. the springs of the spring contacts are "hard". This results, however, in considerable mechanical force that is required to mechanically engage the edge of the board with a number of spring contacts of a telecommunication module. This force is particularly high at a certain insertion depth, at which the edge of the board is mechanically engaged with the resilient contact elements of several spring contacts at the same time.

One such arrangement is shown in the International patent application WO 2004/093275, where an overvoltage protection magazine for a device of telecommunications technology is described, which comprises a printed circuit board, a plurality of overvoltage arresters and contact pads, disposed on the printed circuit board. In the plugged-in state, said contact pads electrically contact the contacts of the telecommunications device.

Efforts have been made in the past to reduce this maximum insertion force by arranging the edge contacts of the boards in a staggered way or by arranging the spring contacts of the telecommunication module in a staggered way, or both.

An example of such efforts is described in the U.S. patent 5 040 991, in which an edge connector accommodates a group of staggered rows of spring contacts for electrical engagement with corresponding rows of correspondingly staggered raised board contacts on one side of a printed circuit board. Upon insertion, spring contacts are lifted by dome-shaped board contacts. One row of board contacts makes electrical contact with one row of spring contacts at a certain insertion depth, and another row of board contacts makes electrical contact with another row of spring contacts at a different insertion depth.

While reducing the required insertion force, this arrangement results in electrical connections being made at different insertion depths, i.e. at different times during the insertion process. This is undesirable in certain telecommunication applications, where electrical components on the board require, for example, voltage supply and grounding at the same time.

It is therefore desirable to provide a board having contacts, which can be engaged with linearly-aligned resilient contact elements of a telecommunication module with a reduced insertion force, wherein electrical connections between contacts of the board and corresponding spring contacts of the telecommunication module are established at one single insertion depth, i.e. at one time during the insertion process. It is also desirable to provide a combination of a board and a telecommunication module having such properties.

The present invention is addressing these needs. The invention provides a board for insertion into a telecommunication module in an insertion direction, the board comprising a substrate, having two major surfaces, first and second conductive paths, arranged on a major surface of the substrate, for electrically contacting first and second spring contacts of a linearly-arranged row of spring contacts of the telecommunication module wherein the first and second conductive paths are arranged such that a contacting end of each of the conductive paths is located on a straight reference line which is substantially perpendicular to the insertion direction, so that electrical connections between respective spring contacts and the respective conductive paths are established at one single insertion depth. The substrate is shaped such that mechanical engagement between parts of the substrate which are to engage mechanically with the first and second spring contacts, respectively, and respective spring contacts is completed at different insertion depths of the board into the telecommunication module.

According to the invention, mechanical engagement between parts of the substrate, which are to engage mechanically with spring contacts of a telecommunication module, and corresponding spring contacts is completed at different insertion depths. In other words, different parts of the board engage with linearly-aligned spring contacts of a telecommunication module at different insertion depths. Electrical connections between conductive paths of the board and spring contacts of the telecommunication module are established at one single insertion depth. A shape of an insertion edge of the board according to the invention reduces the maximum insertion force required, because at a certain insertion depth, not the entire insertion edge of the board , but only a part or parts of it, engage mechanically with spring contacts. Only parts of the insertion edge of the board are, for example, forced into mechanical engagement with resilient contact elements of spring contacts, whereas an other part or other parts of the insertion edge are forced into mechanical engagement with other resilient contact elements of other contact springs at a different insertion depth. The insertion force is thereby reduced with respect to a traditional board, wherein all parts of the insertion edge of the board were forced into mechanical engagement with resilient contact elements of spring contacts at the same insertion depth.

Insertion depth may be a measure for advancement of the board from an un-inserted position, where the board is not inserted into the telecommunication module, towards its fully inserted position, in which the board is inserted deep enough into the telecommunication module, so that it abuts a mechanical stop and/or contacts on the board establish electrical connections with respective corresponding contacts in the telecommunication module, and/or parts of the board mechanically engage with corresponding elements of the telecommunication module.

An insertion direction may be a direction, into which the board needs to be moved in order to mechanically and/or electrically engage with spring contacts of the telecommunication module. Many telecommunication modules require the board to be pushed in one direction into mechanical and/or electrical engagement with spring contacts. This direction may be the insertion direction.

The substrate may be non-conductive. As a consequence, at a certain insertion depth, a part of the board may bend resilient contact elements of a spring contact away, but this may not establish an electrical contact to that spring contact. Electrical contact of a conductive path on that part of the substrate to that spring contact of the telecommunication module may be established at a greater insertion depth of the substrate.

The telecommunication module may be, for example, a telecommunication connection strip or a telecommunication disconnection strip or a telecommunication switching strip. It may also be, for example, an edge connector for a board.

A plurality of parts of the substrate may bend resilient contact elements of several spring contacts away, without establishing any electrical contact to those spring contacts. Electrical connections of conductive paths on those parts of the substrate to those spring contacts of the telecommunication module may be established at a greater insertion depth of substrate, common to all those parts of the substrate, because the conductive paths on those parts of the substrate end on the same reference line.

A contacting end of a conductive path may be the part of the conductive path which extends furthest from a central area of the board into the insertion direction. The contacting end of a conductive path may be a part of the conductive path that contacts a spring contact of the telecommunication module before any other part of the conductive path contacts that spring contact, when the board is gradually inserted into the telecommunication module. Conductive paths may be considered to be separate, if they extend separately for a part of their lengths, although they might be electrically connected at their ends.

In a further aspect, the invention provides a board as described above, wherein a part of the substrate, which is to engage mechanically with a spring contact of the telecommunication module, is shaped to form an insertion tab. Such insertion tabs are advantageous in that they allow for mechanical decoupling of parts of the substrate which are to engage mechanically with one spring contact from parts of the substrate which are to engage with another spring contact. This in turn may facilitate easier insertion of the board into a telecommunication module. It may also help to accommodate accidental variations in the position or orientation of the spring contacts of the telecommunication module.

In a further aspect of the invention, the insertion tab has an elongate shape. An elongate shape is beneficial in that it may allow the board to be used with a telecommunication module which has contacts that are arranged deep inside the telecommunication module into which the board or parts of the board can be inserted. For example, an elongate shape may be beneficial for a board that is to be inserted into a telecommunication connection strip or module which is equipped with connection contacts or switching contacts located close to the center of the strip.

In a further aspect of the invention, the insertion tab protrudes from a central portion of the substrate in the insertion direction. Such an arrangement is advantageous in that the insertion force may act in a direction along the insertion tab, which in turn may allow the insertion tab to be thinner. A central portion of the substrate may be the portion that is close to the center of gravity of the substrate, and which in itself comprises no protrusions or indentations.

In another aspect of the invention, the board comprises a further conductive path on the major surface of the part of the substrate, which is to engage mechanically with the first or second resilient contact element. This further conductive path may allow for a higher number of electrical contacts with a telecommunication module without having to increase the width of the board. The further conductive path may be arranged next to and close to the first or the second conductive path, so that it may contact the same spring contact of a telecommunication module as the first or the second conductive path. It may thereby provide a more reliable electrical contact between the telecommunication module and the board.

In another aspect of the invention, the board comprises a further conductive path on the major surface of the part of the substrate, which is opposite to the major surface of the part of the substrate which is to engage mechanically with the first or second resilient contact element. This further conductive path, arranged on the opposite surface, may allow for a higher number of electrical contacts with a telecommunication module without having to increase the width of the board. In the case of a telecommunication module, in which a single spring contact can make electrical contact with conductive paths arranged on both major surfaces of the substrate, the further conductive path may also be used to contact the same spring contact a telecommunication module as the first or second conductive path contacts, and thereby provide a more reliable electrical contact between the telecommunication module and the board.

In another aspect of the invention, parts of the substrate, which are to engage mechanically with the first and second spring contacts, respectively, extend to a greater distance from the reference line, as measured in the insertion direction, than the parts of the substrate, which are to engage mechanically with further spring contacts, the further spring contacts being located between the first and the second spring contacts. This arrangement may be beneficial in order to facilitate insertion of the board into a telecommunication module with less risk of jamming, because the parts of the substrate, which are to mechanically engage with the first and second contact spring, respectively, may be inserted into corresponding spring contacts first, and they then may act as guides for the insertion of the parts of the substrate, which are to engage with the further spring contacts.

In another aspect, the board according to the invention comprises an overvoltage arrester or a splitter circuit or a test access. These types of electrical components may make the board particularly suitable for use in telecommunication networks.

In another aspect, a part of the substrate, which is to mechanically engage with a spring contact of a telecommunication module, has a tapered edge for facilitating insertion. A tapered edge may be particularly beneficial for smooth mechanical engagement with resilient contact elements of spring contacts wherein the resilient contact elements have a high spring constant. A tapered edge may contribute to further reducing insertion force of the board into the telecommunication module.

In another aspect of the invention, the board is adapted to mechanically engage with spring contacts of a telecommunication connection strip or of a telecommunication disconnection strip or of a telecommunication switching strip. This is advantageous in that it may make the board particularly suitable for use in telecommunication networks. The board may, for example, be particularly thin or stiff or have a particular shape to make it suitable for insertion into spring contacts of those components.

Telecommunication strips or modules often comprise a plastic housing and elongate metallic contacts in a parallel arrangement inside the housing, that extend from a side of the housing to an opposite side. Telecommunication wires can be secured to the contacts on both ends of the contacts. These contacts may comprise, in their middle portion and located deep inside the housing, spring contacts between which a board can be inserted in order to establish electrical connections between contacts and electrical components on the board. Openings are provided in the housing, so that a board or boards can be inserted into the housing for establishing electrical contact. Depending on the type of contacts in the strip, the board may serve to establish or to break electrical connections between spring contacts in the strip, or to establish electrical connections between a spring contact of the strip and an electrical component on the board or outside the board.

The board may be a printed circuit board (PCB). In yet another aspect of the invention, the PCB is a multilayer PCB. A multilayer PCB provides greater flexibility in arranging conductive paths on the PCB. Conductive paths, arranged on a major surface of the substrate, may be connected to other electrical elements on the PCB through buried conductors, which may also reduce the risk of accidental short-circuits.

In another aspect, the invention provides a combination of a board as described above, and a telecommunication module comprising a linearly-aligned row of resilient contact elements. This combination may provide reduced insertion force when inserting the board into the spring contacts of the telecommunication module.

### Short description of the Figures

The invention will now be described in more detail with reference to the following
Figures, exemplifying particular embodiments of the invention.
Figure 1: Perspective view of a printed circuit board according to the invention;
Figure 2: Perspective view of an alternative printed circuit board according to the invention;
Figure 3a: Perspective view of an alternative printed circuit board in accordance with the present invention;
Figure 3b: Telecommunication module, into which the printed circuit board of Figure 3a can be inserted;
Figure 4: Cross section, showing a printed circuit board in accordance with the present invention, partly inserted into a telecommunication module;
Figure 5: Cross section, showing the printed circuit board of Figure 4 being inserted deeper into the telecommunication module;
Figure 6: Cross section, showing the printed circuit board of Figure 4 fully inserted into the telecommunication module;
Figure 7a: Cross section, showing a further embodiment of a printed circuit board according to the invention, with conductive paths on both major surfaces, extending to the same distance;
Figure 7b: Cross section, showing a further embodiment of a printed circuit board according to the invention, with conductive paths on both major surfaces, extending to different distances;
Figure 8a: Cross section, showing a printed circuit board as in Figure 7a, in a different telecommunication module;
Figure 8b: Cross section, showing a printed circuit board as in Figure 7b, in a different telecommunication module;
Figure 9a: Perspective view of a further embodiment of the printed circuit board according to the invention, having a buried conductor; and
Figure 9b: Cross section, showing a the printed circuit board of Figure 9a and of a spring contact of a telecommunication module;
Figure 10: Perspective view of a further printed circuit board according to the invention;
Figure 11: Cross section, showing a telecommunication module, into which a printed circuit board can be inserted;
Figure 12: Perspective view of a further printed circuit board according to the invention; and
Figure 13: Diagram of insertion force versus insertion depths for a printed circuit board according to one embodiment of the invention.

### Detailed Description of the Figures

Herein below various embodiments of the present invention are described and shown in the drawings, wherein like elements are provided with the same reference numbers.

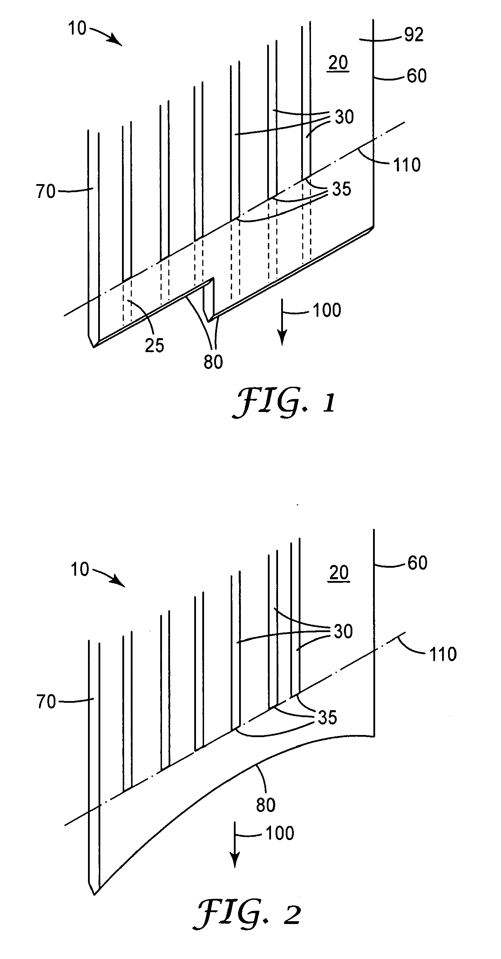

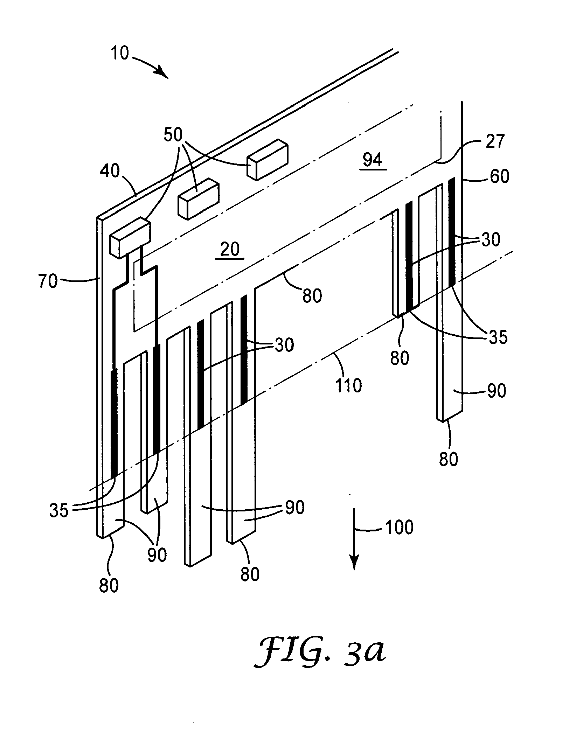

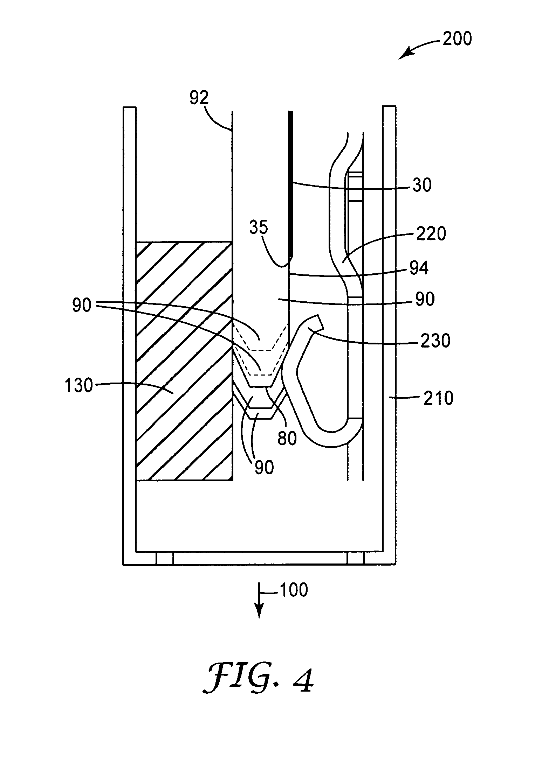

**Figure 1** is a perspective view of a printed circuit board ("PCB") 10 according to the invention. The PCB 10 is to be inserted into a telecommunication module in an insertion direction indicated by arrow 100. The PCB 10 comprises a flat, electrically non-conductive substrate 20. The PCB 10 has side edges 60, 70, and an insertion edge 80 extending between the side edges 60 and 70. Flat conductive paths 30 are arranged on a major surface 92 of the substrate 20. Each conductive path 30 has a contacting end 35, with which the conductive path 30 will first touch a corresponding resilient contact element (shown for example in Figures 3a, 4) in the telecommunication module 200 (not shown), when the PCB 10 is inserted into the telecommunication module 200 in the insertion direction 100. A straight reference line 110 indicates the location of the contacting ends 35. The reference line 110 is substantially perpendicular to the insertion direction 100. When the PCB 10 is inserted into a telecommunication module, certain parts 25 of the substrate 20 are to mechanically engage with resilient contact elements of the telecommunication module. These parts 25 may, for example, bend the resilient contact elements of spring contacts away. The insertion edge 80 has a stepped shape. The insertion edge 80 on both sides of the step is straight. In other words, parts 25 of the substrate 20, which are to mechanically engage with resilient contact element of a telecommunication module, extend to two distinctly different distances from the reference line 110, as measured in the insertion direction 100.

**Figure 2** is a perspective view of a further printed circuit board 10 according to the invention. The embodiment shown in Figure 2 differs from that shown in Figure 1 in that the insertion edge 80 of the embodiment of Figure 2 has a curved shape. Outer parts of the substrate 20 which are closer to the side edges 60, 70 of the PCB 10, extend to a greater distance from the reference line 110, as measured in the insertion direction 100, than other parts of the substrate 20 located between the outer parts. This results in mechanical engagement between parts 25 of the substrate 20, which are to engage mechanically with resilient contact elements (not shown) of a telecommunication module, and those resilient contact elements being completed at different insertion depths of the PCB 10 into the telecommunication module 200.

The curved shape of the insertion edge 80 of the PCB 10 helps to avoid skew insertion of the PCB 10 into the telecommunication module 200, because the outer parts of the PCB 10 contact their corresponding resilient contact elements before other parts contact their corresponding resilient contact elements, and thereby stabilize the PCB 10 against tilting.

**Figure 3a** shows, in perspective view, a different PCB 10 according to the invention. The PCB 10 comprises a flat non-conductive substrate 20 and flat conductive paths 30 arranged on a major surface 94 of the substrate 20. The other major surface, parallel to the major surface 94, is not visible in this Figure. Close to an upper edge 40 of the PCB 10, a number of overvoltage arresters 50 are arranged. They may serve to protect electronic components, e.g. of the telecommunications module into which the PCB is inserted against voltage spikes. Each overvoltage arrester 50 is electrically connected to two of the conductive paths 30. Instead of overvoltage arresters 50, other electric or electronic components may be arranged on the PCB 10. Alternatively, no electric or electronic components at all may be arranged on the PCB 10. In this case, the PCB 10 merely provides conductive paths to electrical or electronic components which are not arranged on the PCB 10. In other embodiments, the PCB 10 provides conductive paths for electrically connecting resilient contact elements 230 of a telecommunication module 200 with each other.

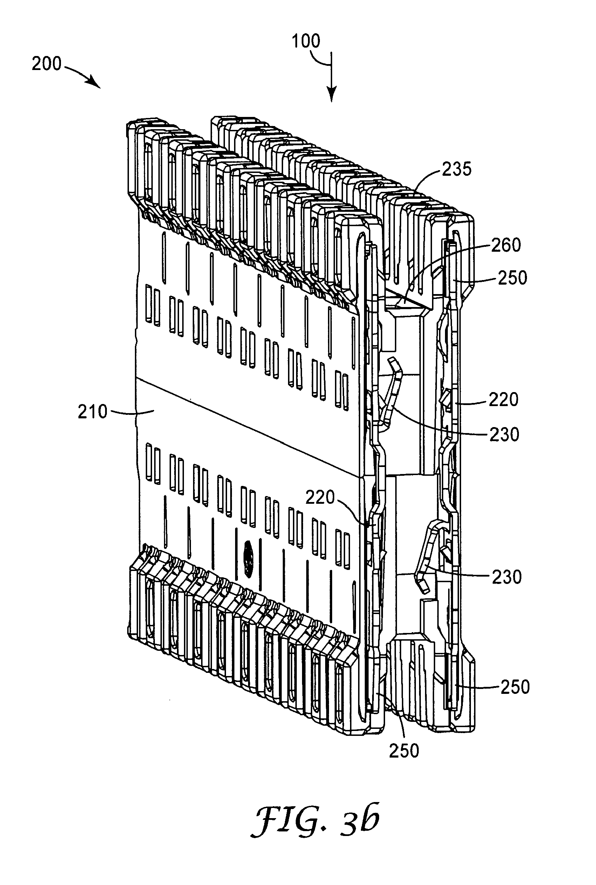

The upper edge 40 extends between two side edges 60 and 70 of the PCB 10. An insertion edge 80 of the PCB 10 also extends between the side edges 60 and 70. The parts of the substrate 20 which are to engage mechanically with spring contacts (shown in Figure 3b) are shaped to form a number of elongate insertion tabs 90, which protrude from a central portion 27 of the substrate 20 in the insertion direction 100. In this embodiment, the insertion tabs 90 are parts 25 of the substrate 20 which are to engage mechanically with resilient contact elements 230 of a telecommunication module 200 (shown in Figure 3b). All insertion tabs 90 protrude in the same direction. The direction 100 is the insertion direction of the PCB 10 into a telecommunication module 200. In the embodiment shown in Figure 3a each tab 90 provides an insertion edge 80 which lies opposite the upper edge 40 of the PCB 10. The insertion edges 80 may be tapered.

The conductive paths 30 have a linear shape. They have contacting ends 35. The contacting end 35 of each of the conductive paths 30 is located on a straight reference line 110, which is substantially perpendicular to the insertion direction 100. Some of the insertion tabs 90 protrude to different distances from the straight reference line 110, as measured in the insertion direction 100.

Due to the insertion tabs 90 having an elongate shape, the insertion tabs 90 are resilient and can be bent out of the plane of the substrate 20 to some degree. Spacing between adjacent insertion tabs 90 is provided in order for the insertion tabs 90 to be resiliently bendable independently from each other. The insertion tabs 90 being resilient and being independently bendable facilitates the manual insertion of the PCB 10 into a telecommunication module 200 (as shown in Figure 3b) and helps mechanically engaging the insertion tabs 90 with resilient contact elements 230 of spring contacts 220, thereby coping with, for example, any imperfect arrangement or orientation of the spring contacts 220 in the telecommunication module 200 or slight variations in the insertion direction.

The conductive paths 30 on the insertion tabs 90 extend outwardly from a central portion 27 of the PCB 10. Their contacting ends 35 are located on the reference line 110. In other words, the conductive paths 30 have the same lengths relative to the reference line 110. Because the conductive paths 30 on the insertion tabs 90 have the same lengths, electrical connections between respective resilient contact elements 230 of a linearly-aligned row of resilient contact elements 230 of a telecommunication module 200 and the respective conductive paths 30 are established at one single insertion depth of the PCB 10 into the telecommunication module 200.

**Figure 3b** is a perspective view of a telecommunication module 200, into which the PCB 10 of Figure 3a can be inserted. It comprises a housing 210 and two linearly-aligned rows of elongate conductive spring contacts 220, each contact comprising a conductive resilient contact element 230 (shown in greater detail in Figure 4). In this embodiment, the resilient contact element 230 is a resilient arm 230. Only one spring contact 220 of each row is visible in the Figure. By inserting the PCB 10 into the telecommunication module 200, each insertion tab 90 is pushed between a resilient contact element 230 and an opposed solid counter surface (shown in Figure 4) of the telecommunication module 200, whereby the insertion tab 90 mechanically engages with the resilient contact element 230 of the spring contact 220. Mechanical engagement between an insertion tab 90 of the PCB 10 and a corresponding spring contact 220 is completed, once the PCB 10 has been inserted to a sufficient insertion depth into the telecommunication module 200, that the insertion tab 90 has bent the resilient contact element 230 of the spring contact 220 such that the resilient contact element 230 still touches or presses against the PCB 10 with a predetermined force to provide the possibility of reliable electrical connection.

At a greater insertion depth, an electrical connection is established between the conductive path 30 on the PCB 10, e.g. the insertion tab 90, and the spring contact 220 through the resilient contact element 230 of the spring contact 220. The conductive paths 30 are very thin, so that their contacting ends 35 create a very low step on the surface of the insertion tab 90, so that only negligible additional force for insertion is required, when the contacting end 35 engages with the spring contact 220.

The resilient contact elements 230 of the embodiment of the telecommunication module 200 shown in Figure 3b are aligned in two linearly-arranged rows in that, within one row, their respective distances relative to an upper edge 235 of the telecommunication module 200, into which the PCB 10 is inserted, is the same for all resilient contact elements 230, as measured in the insertion direction 100.

When the PCB 10 of Figure 3a is inserted into the telecommunication module 200 of Figure 3b, the longest insertion tab 90 (or several longest insertion tabs 90) is the first to mechanically engage with a first spring contact 220, in particular with a first resilient contact element 230 in a linearly-arranged row of resilient contact elements 230 in the telecommunication module 200. A certain force is required to bend the resilient arm 230 forming the resilient contact element 230 of the first spring contact 220 and push this longest insertion tab 90 into a position between the first resilient contact element 230 of the first spring contact 220 and a solid counter surface (shown in Figure 4) of the telecommunication module 200. When the PCB 10 is inserted further, the second-longest insertion tab 90 (or several second longest insertion tabs 90) will contact a second resilient contact element 230 of a second spring contact 220, and require some force to bend the second resilient contact element 230 of that second spring contact 220 away. As a result, mechanical engagement between both the longest and the second-longest insertion tabs 90 and respective first and second spring contacts 220 is completed. However, because the insertion tabs 90 were mechanically engaged with the two spring contacts 220sequentially, the maximum insertion force required was lower than it would have been, if both insertion tabs 90 had been mechanically engaged with the two respective spring contacts 220 simultaneously. This is because the two respective resilient contact elements 230 of the two spring contacts 220 were bent one after the other rather than at the same time. By virtue of this, the maximum insertion force, that is required to insert the PCB 10 of the present invention into the telecommunication module 200, is reduced with respect to previously known PCBs where insertion tabs had the same length.

At a certain insertion depth of the PCB 10 into the telecommunication module 200, electrical connections between conductive paths 30 on the insertion tabs 90 and respective spring contacts 220, in particular with their conductive resilient contact elements 230, are established. The electrical connections are established at substantially the same insertion depth, because the resilient contact elements 230 are arranged in a linearly-aligned row, and because the contacting ends 35 of the conductive paths 30 on the PCB 10, e.g. the insertion tabs 90, are located on the reference line 110.

The spring contacts 220 may, for example, be of the switching contact type, of the disconnection contact type or of the connection contact type, which are well known in the field of telecommunications. The spring contacts 220 shown in this Figure extend longitudinally from one side (e.g. from the side of the upper edge 235) of the telecommunication module 200 to the opposite side. At each end of a spring contact 220, an externally accessible insulation displacement contact 250 is provided, which serves to secure wires (not shown) to the respective spring contacts 220.

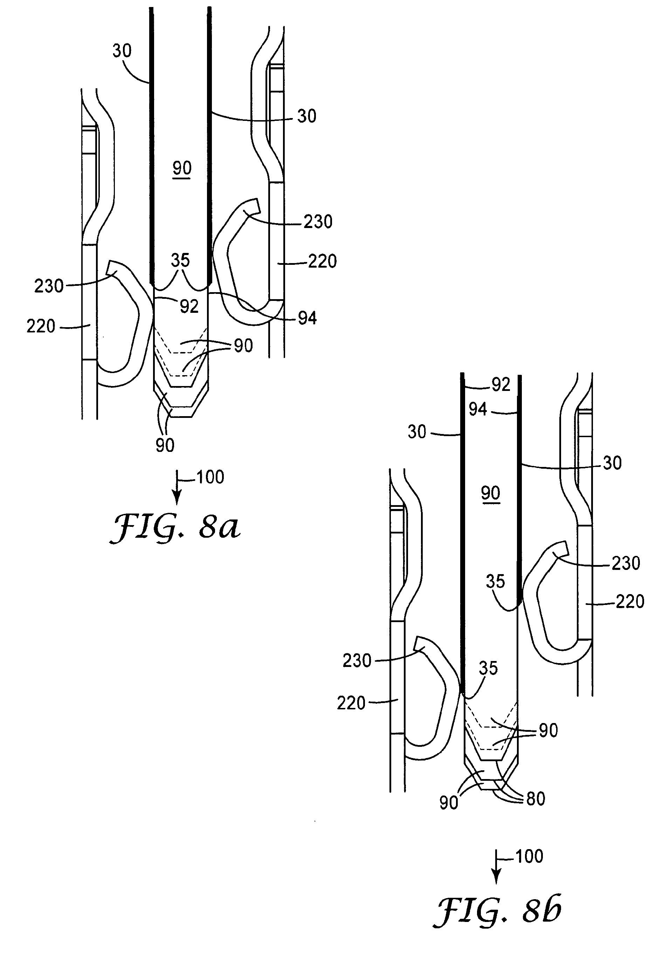

A spring contact 220 may have more than one resilient contact element 230. It may, for example, have two resilient contact elements 230. These resilient contact elements 230 may be located at the same insertion depth or at different insertion depths. One row of resilient contact elements 230 on one side of the telecommunication module 200 may be linearly-aligned at a certain insertion depth, whereas another row of resilient contact elements 230 on another side of the telecommunication module 200 may be linearly-aligned at a different insertion depth. This latter case is illustrated in Figure 8b.

Openings 260 are provided on one side of the housing 210 of the telecommunications module 200. The PCB 10 of Figure 3a can be inserted into the telecommunication module 200 such that the insertion tabs 90 are inserted into the openings 260. In the embodiment shown, one opening 260 is provided for each insertion tab 90, but other arrangements may be contemplated, for example, to provide one larger opening 260 for two insertion tabs 90, or to provide one large opening 260 in the form of a slit such that all insertion tabs 90 on an insertion edge 80 of the PCB 10 can be inserted into that opening 260, or such that a part of the substrate 20 of the PCB 10, not forming any insertion tabs 90, can be inserted into that opening 260.

A spring contact 220 of a telecommunication module 200, into which a part of the PCB 10 of Figure 3a, the part forming insertion tabs 90, is partly inserted, is shown in **Figure 4** in cross-section and in greater detail.

The substrate 20 has two major surfaces 92, 94. On one major surface 94, a conductive path 30 is arranged. A resilient contact element 230 of spring contact 220 is electrically conductive so that it can establish an electrical connection with the conductive path 30 on the insertion tab 90, once the PCB 10 is inserted deep enough into the telecommunication module 200. In order to facilitate insertion, the resilient contact element 230 is shaped to guide the tip of the corresponding insertion tab 90 into the space between the resilient contact element 230 and a solid counter surface 130 of the telecommunication module 200. As a further measure to facilitate insertion of the PCB 10, the end portion or insertion edge 80 of each insertion tab 90 is tapered.

Figure 4 shows one insertion tab 90 in a position of initial mechanical engagement with the spring contact 220. At the insertion depth shown in this Figure, there is no electrical connection between the conductive path 30 on the insertion tab 90 and the conductive resilient contact element 230 of the spring contact 220. Further insertion tabs 90 are located behind and in front of the front most one in this Figure. They all have a different extension measured from the reference line 110.

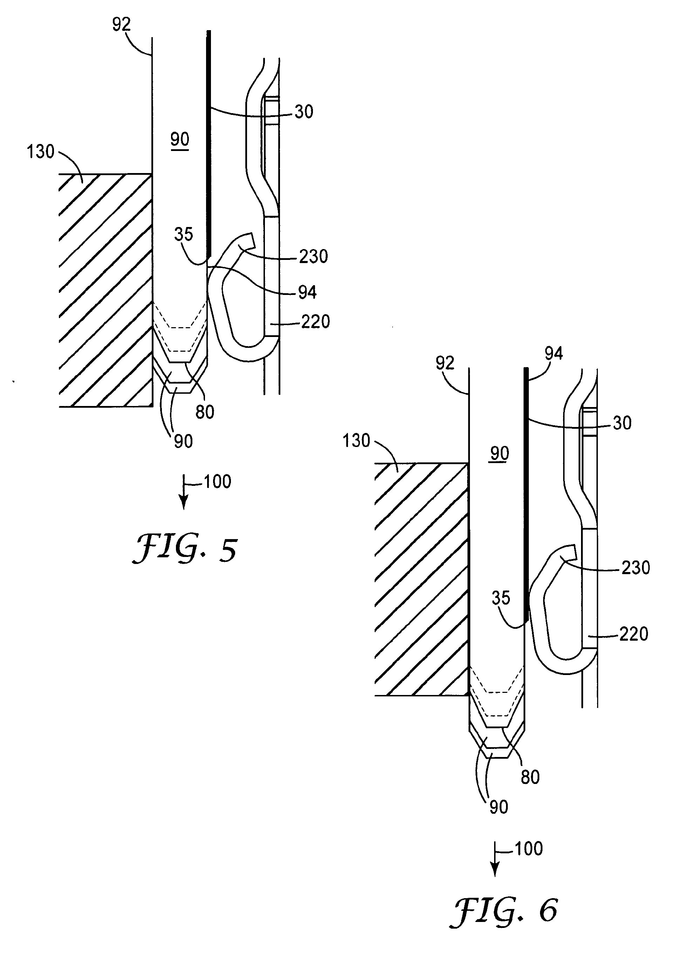

**Figure 5** shows a cross section the PCB 10 of Figures 3a and 4, inserted deeper into the telecommunication module 200 of Figure 3b. The insertion tab 90 has bent the resilient contact element 230 of the spring contact 220 such that the resilient contact element 230 still touches or presses against the PCB 10 with a predetermined force to provide the possibility of reliable electrical connection. However, at the insertion depth shown, the conductive resilient contact element 230 is not in electrical connection with the conductive path 30 on the surface 94 of the insertion tab 90.

In the cross section of **Figure 6****,** the PCB 10 has been inserted into the telecommunication module 200 deep enough for the conductive path 30 on the insertion tab 90 of the PCB 10 to be in electrical connection with the conductive resilient contact element 230 of the spring contact 220.

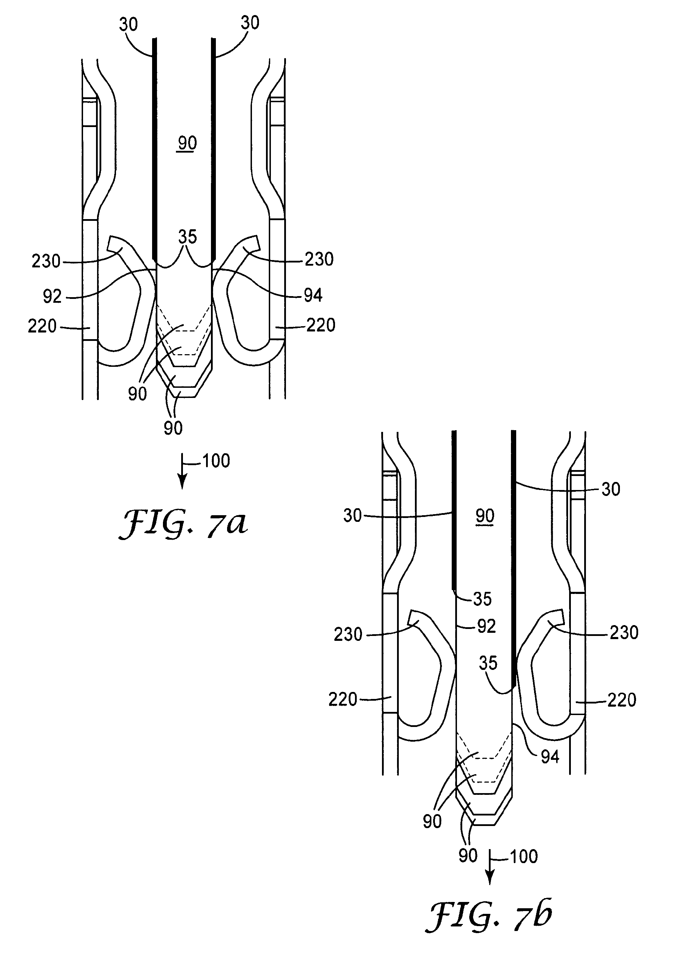

Conductive paths 30 may be provided on both major surfaces 92, 94 of the substrate 20, as is shown in the cross section of **Figure 7a**. This Figure shows a PCB 10 according to the invention, having insertion tabs 90. The conductive paths 30 on the major surfaces 92, 94 of the front most insertion tab 90 are indicated in this Figure. They extend on both sides to the same length, i.e. their contacting ends 35 end on reference lines 110 which are located at the same insertion depth. The telecommunications module 200 in this Figure is different from the one of Figures 4 to 6 in that it has two opposing spring contacts 220 engaging mechanically with the one insertion tab 90. Each of the spring contacts has a resilient contact element 230, these resilient contact elements 230 face each other. In this embodiment mechanical engagement between the PCB 10 and the spring contacts 220 is made at different insertion depth and electrical connection between the conductive paths 30 of the PCB 10 and the spring contacts 220 is made at the same insertion depth.

The location of contacting ends 35 of the conductive paths 30 on one major surface 92, 94 of the PCB 10 may be different from the location of contacting ends 35 of conductive paths 30 on the other major surface 92, 94 of the PCB 10. This is shown in **Figure 7b**. One reference line 110 may exist for defining the locations of contacting ends 35 of conductive paths 30 arranged on one major surface 92, 94 of the substrate 20, while a different reference line 110, in a different position, may exist for defining the locations of contacting ends 35 of conductive paths 30 arranged on the other major surface 92, 94 of the substrate 20. In the embodiments shown in Figures 7a and 7b, no counter surface 130 is required to keep the insertion tabs 90 in position, because one resilient contact element 230 is arranged on each side of the PCB 10.

In a further embodiment, conductive paths 30 are provided on both major surfaces 92, 94 of the substrate 20, as is shown in **Figure 8a**. Although the contacting ends 35 of the conductive paths 30 on both major surfaces 92, 94 are located on the same reference line 110, an electrical connection is established with resilient contact elements 230 of the spring contact 220 at different insertion depths, because the resilient contact elements 230 are arranged on different insertion depth. When the PCB 10 is inserted gradually into the telecommunication module 200 in the insertion direction 100, one resilient contact element 230 electrically contacts the conductive path 30 on the right side (in this Figure) of the insertion tab 90, before the other resilient contact element 230 contacts the conductive path 30 on the left side of the insertion tab 90.

It may be desired that the conductive paths 30 on opposing sides of the substrate 20 establish electrical connections at the same insertion depth, although opposing resilient contact elements 230 in the telecommunication module 200 might be arranged in a staggered manner. **Figure 8b** shows how that can be achieved: the contacting ends 35 of conductive paths 30 on one major surface 92 of the substrate 20 are located further towards the insertion edge 80 of the PCB 10 than the conductive path 30 on the other major surface 94 of the PCB 10 by such an amount, that, at a certain insertion depth, both conductive paths 30 establish electrical connections with respective corresponding conductive resilient contact elements 230 of spring contacts 220 substantially simultaneously, i.e. at one and the same insertion depth.

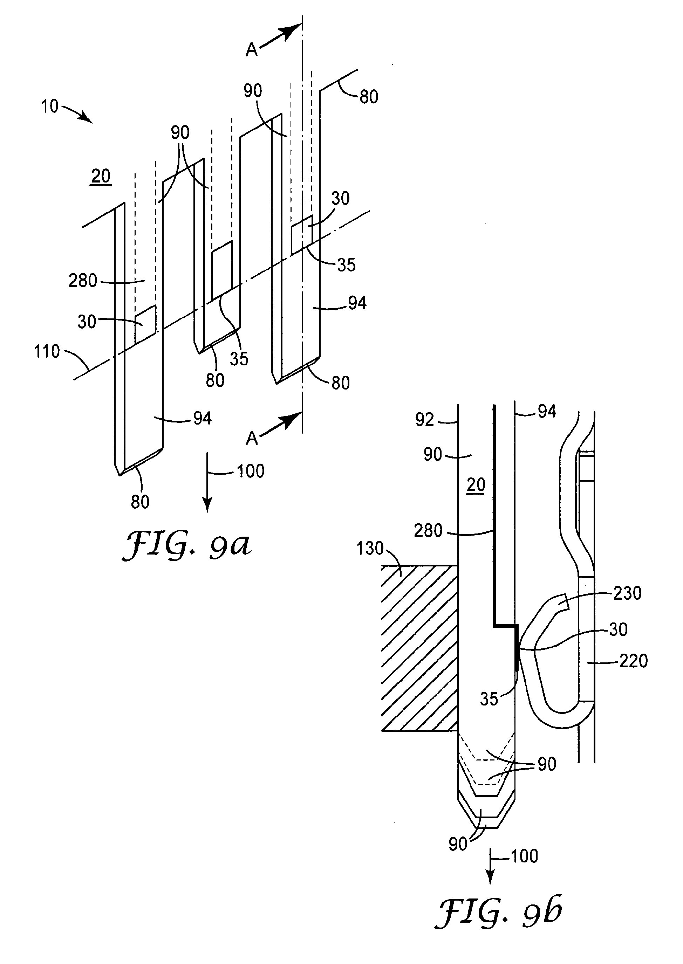

**Figure 9a** shows, in a perspective view, a PCB 10 having insertion tabs 90. Each insertion tab 90 comprises a conductive path 30 on its one major surface 94. Each conductive path 30, in this embodiment, forms a conductive patch 30 or pad 30 on the surface 94. It is noteworthy that the conductive paths 30 forming patches 30 have different sizes, but their contacting ends 35 all extend in the insertion direction indicated by the arrow 100, to the reference line 110. The conductive paths 30 on the surface 94 are electrically connected to for example electrical components on the PCB 10 (not shown) by a buried conductor 280, which is arranged within the non-conductive substrate 20 of the PCB 10. The buried conductor 280 is not externally accessible, while the conductive path 30 is externally accessible and can establish electrical connection with a spring contact 220 of the telecommunication module 200, as is shown in **Figure 9b**. This figure is a cross section of a contact 220 of a telecommunication module 200 and of one of the insertion tabs 90 of Figure 9a, the latter being taken along the line A-A of Figure 9a. In this embodiment, the spring contact 220 comprises only one resilient contact element 230. The PCB 10 has been inserted sufficiently deep into the telecommunication module 200 so that an electrical connection is established between the conductive path 30 and the conductive resilient contact element 230 of spring contact 220.

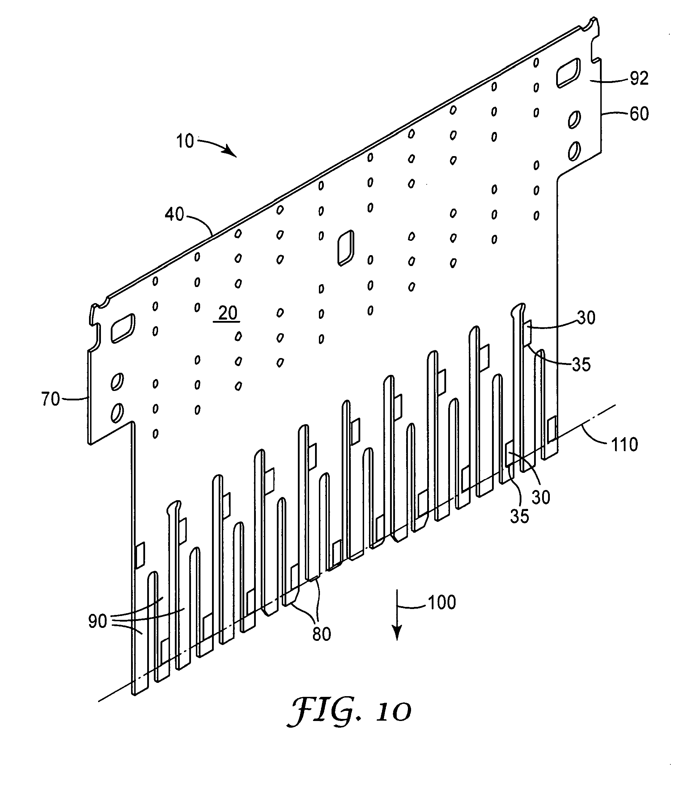

A further embodiment of a PCB 10 according to the invention is shown in **Figure** 10. The PCB 10 has insertion tabs 90, which are the parts of the substrate 20 which are to engage mechanically with a corresponding number of spring contacts 220 of a telecommunication module 200 (not shown in this Figure). On the major surface of each insertion tab 90, which is visible in this Figure, conductive paths 30 are arranged, which are electrically connected to other elements through buried conductors (not shown). One conductive path 30 on each insertion tab 90 is arranged such that its contacting end 35 is located on a straight reference line 110, which is perpendicular to the insertion direction 100. Thereby, electrical connections between respective spring contacts 220 of a telecommunication module and these conductive paths 30 are established at one single insertion depth. The outer insertion tabs 90, i.e. the ones located close to side edges 60, 70 of the PCB 10, extend to a greater distance from the reference line 110, as measured in the insertion direction 100, than some other insertion tabs 90 which are located between the outer insertion tabs 90. The two outermost insertion tabs 90 extend to the same distance from the reference line 110, so that they can facilitate straight insertion into a telecommunication module 200. Some inner insertion tabs 90, however, have different lengths relative to the reference line 110, so that, upon insertion, they bend resilient contact elements 230 of spring contacts 220 (not shown) at different insertion depths, thereby reducing the insertion force required. The insertion edges 80 of the tabs 90 are tapered, which also reduces the insertion force. As can be seen at the insertion tabs 90 which are located between the outer insertion tabs 90, the insertion edge 80 of some tabs 90 are tapered in two directions which results in reduces insertion force because mechanical engagement with the contact elements 220 is facilitated and it results in a guiding of the PCB 10 through openings 260 of a housing 210 of a telecommunication module 200.

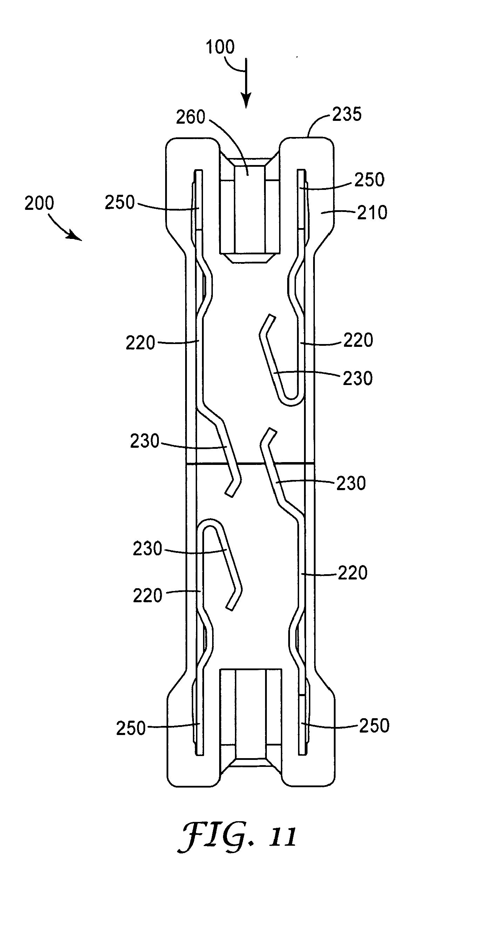

**Figure 11** is a telecommunication module 200 in cross section. This telecommunication module 200 comprises a housing 210 which has openings 260, through which insertion tabs 90 of a PCB 10 according to the invention can be inserted in an insertion direction 100. The telecommunication module 200 has four rows of spring contacts 220, an upper and a lower row on each side. These spring contacts 220 are switching contacts. The four front most spring contacts 220 are visible in this Figure. Each spring contact 220 has an insulation displacement contact 250 at its outer end, and a resilient contact element 230 for establishing electrical connection with a corresponding conductive path 30 of a PCB 10. The upper spring contacts 220 of one row, located closer to an upper edge 235 of the telecommunication module 200, are the first to engage mechanically with the insertion tabs 90 when the PCB 10 is inserted into the telecommunication module 200. At a greater insertion depth, the lower spring contacts 220 engage mechanically with the insertion tabs 90. In this embodiment the resilient contact element 230 of the upper right spring contact 220 is first mechanically engaged with the PCB 10; secondly the resilient contact element 230 of the upper left spring contact 220 is mechanically engaged with the PCB 10; thirdly the resilient contact element 230 of the lower right spring contact 220 and than the resilient contact element 230 of the lower left spring contact 220 is mechanically engaged with the PCB.

When the PCB 10 is fully inserted, electrical connections are established between conductive paths 30 located closer to a central portion of the PCB 10 and the upper row of spring contacts 220, and also between conductive paths 30 located further from a central portion of the PCB 10 and the lower row of spring contacts 220; i.e. the row which is located further from the upper edge 235 of the telecommunication module 200.

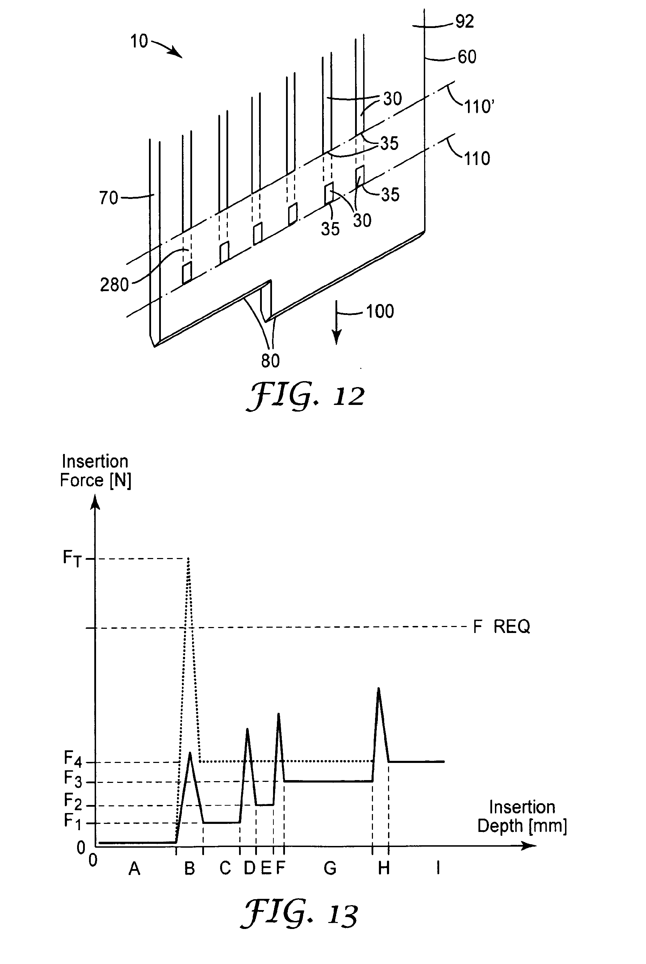

**Figure 12** shows, in a perspective view, a further embodiment of a PCB 10 according to the invention. The PCB 10 is a multilayer PCB 10, because it has conductors below a surface 92 of its substrate 20. A first group of conductive paths 30 have their contacting ends 35 located on a first reference line 110', a second group of conductive paths 30 have their contacting ends 35 located on a second reference line 110. The second reference line 110 is located closer to the insertion edge 80 of the PCB 10 than the first reference line 110'. The conductive paths 30 of the first group are in register, i.e. in the same lateral position with respect to side edges 60, 70 of the PCB, with the conductive paths 30 of the second group. The conductive paths 30 of the second group are electrically connected to for example electrical components (not shown) on the PCB 20 through buried conductors 280 located under the major surface 92 of the substrate. The conductive paths 30 of the first group are electrically connected to for example electrical components (not shown) on the PCB 20 through conductors on the surface 92 of the substrate 20.

**Figure 13** is a diagram in which insertion forces are shown on the y-axis and insertion depth is shown on the x-axis. The solid line represents an insertion force for a PCB 10 according to one embodiment of the present invention as it is inserted gradually deeper into a telecommunication module 200, and mechanical engagement between parts of the substrate of the PCB 10 and respective spring contacts 220 of the telecommunication module 200 is completed. In range A of the insertion depth, virtually no force is required to insert the PCB 10 into the telecommunication module 200, because no parts of the PCB substrate 20 engage with any spring contacts 220 of the telecommunication module 200. In range B, a first part of the substrate 20 (for example, an insertion tab 90 as shown in Figures 3a, 9a, 10) engages mechanically with a corresponding first spring contact 220. The insertion force rises quickly, as the first part 25 of the substrate 20 bends a resilient contact element 230 of the first spring contact 220. Once mechanical engagement between this first part 25 of the substrate 20 and the first spring contact 220 is completed, the insertion force drops to a lower value F1, which is the force that is required to overcome the friction between the first part 25 of the substrate 20 and the first spring contact 220, as the PCB 10 is inserted deeper into the telecommunication module 200. In range C, the PCB 10 is inserted deeper into the telecommunication module 200, and only the frictional force F1 of the first spring contact 220 needs to be provided for further insertion. At a greater insertion depth, in range D, a second part 25 of the substrate 20 touches a second spring contact 220. A peak force is required to bend a resilient contact element 230 of the second spring contact 220. The height of the peak is related to for example the "hardness" of the resilient contact element 230 of the spring contact 220. Once the resilient contact element 230 is bent, less force is required to insert the PCB deeper, hence the drop immediately after the peak. In range E, a force F2, greater than F1, is required to push the PCB 10 deeper into the telecommunication module 200, because the friction generated between the first part 25 and the first spring contact and, in addition, the friction generated between the second part 25 of the substrate 20 and the second spring contact 220 needs to be overcome to insert the PCB 10 further. Range F comprises a further peak force for a third part 25 of the substrate to bend a resilient contact element 230 of a third spring contact 220, and, in range G, the frictional force F3 is required to insert the PCB 10 deeper, since now three spring contacts 220, engaged mechanically with three parts 25 of the substrate 20, generate frictional force. Ranges H and I show the insertion force during and after engagement of a fourth part 25 of the substrate 20 with a fourth spring contact 220. The extension of the "friction-only" ranges C, E, G and I is determined by the extensions of the respective parts 25 of the substrate 20 relative to the reference line 110, measured in the insertion direction 100, for example by the length of the insertion tabs 90.

Figure 13 also shows, in a dotted line, the insertion force required to insert a traditional PCB into the same telecommunication module. Since an edge of a traditional PCB is bends the resilient contact elements of first, second, third and fourth spring contacts at one and the same insertion depth, the force FT is required to insert the traditional PCB. FT is about four times as high as one of the insertion force peaks in ranges B, D, F or H. It can be seen from this diagram that the highest peak in the range H is still much lower than FT and even lower than F REQ, a threshold for insertion forces that is selected such that it can easily be overcome when the PCB is inserted by hand and no other tools are used.

## Claims

1. A board for insertion into a telecommunication module (200) in an insertion direction (100), the printed circuit board (10) comprising
- a substrate (20), having two major surfaces (92, 94),
- first and second conductive paths (30), arranged on a major surface of the substrate (20), for electrically contacting first and second resilient contact elements (230) of a linearly-arranged row of resilient contact elements (230) of the telecommunication module (200),
wherein the first and second conductive paths (30) are arranged such that a contacting end (35) of each of the conductive paths (30) is located on a straight reference line (110) which is substantially perpendicular to the insertion direction (100), so that electrical connections between respective resilient contact elements (230) and the respective conductive paths (30) are established at one single insertion depth,
**characterized in that**
the substrate (20) is shaped such that mechanical engagement between parts (25) of the substrate (20) which are to engage mechanically with the first and second resilient contact elements (230), respectively, and respective resilient contact elements (230) is completed at different insertion depths of the board into the telecommunication module (200).

2. Board according to claim 1, wherein a part (25) of the substrate (20), which is to engage mechanically with a resilient contact element (230) of the telecommunication module (200), is shaped to form an insertion tab (90).

3. Board according to claim 2, wherein the insertion tab (90) has an elongate shape.

4. Board according to any one of claims 2 or 3, wherein the insertion tabs (90) protrude from a central portion of the substrate (20) in the insertion direction (100).

5. Board according to any one of the previous claims, wherein the board comprises a further conductive path (30) on the major surface (92, 94) of the part (25) of the substrate (20), which is to engage mechanically with the first or second resilient contact element (230).

6. Board according to any one of the previous claims, wherein the board comprises a further conductive path (30) on the major surface (92, 94) of the part (25) of the substrate (20) which is opposite to the major surface (92, 94) of the part (25) of the substrate (20) which is to engage mechanically with the first or second resilient contact element (230).

7. Board according to any one of the previous claims, wherein the parts (25) of the substrate (20), which are to engage mechanically with the first and second resilient contact elements (230), respectively, extend to a greater distance from the reference line (110), as measured in the insertion direction (100), than the parts (25) of the substrate (20), which are to engage mechanically with further resilient contact elements (230), the further resilient contact elements (230) being located between the first and the second resilient contact elements (230).

8. Board according to any one of the previous claims, wherein the board comprises an overvoltage arrester (50) or a splitter circuit or a test access.

9. Board according to any one of the previous claims, wherein a part (25) of the substrate (20), which is to mechanically engage with a resilient contact element (230) of a telecommunication module (200), has a tapered edge for facilitating insertion.

10. Board according to any one of the previous claims, wherein the board is adapted to mechanically engage with resilient contact elements (230) of a telecommunication connection strip or of a telecommunication disconnection strip or of a telecommunication switching strip.

11. Board according to any one of the previous claims, wherein the board is a printed circuit board (10).

12. Board according to claim 11, wherein the printed circuit board (10) is a multilayer printed circuit board.

13. Combination of a board according to any one of the previous claims and a telecommunication module (200) comprising a linearly-aligned row of resilient contact elements (230).
